# EUROPEAN PATENT SPECIFICATION

(11) **EP 2 398 059 B1**
(45) Date of publication and mention of the grant of the patent: **31.10.2018**
(21) Application number: 10166542.0
(22) Date of filing: 18.06.2010
(51) Int. Cl.: H02S 20/25, H01L 31/02

(54) **Roof with roof tile provided with solar cells**
Dach mit Dachziegel, der mit Solarzellen ausgerüstet ist
Toiture avec tuile de toiture équipée de cellules solaires

(43) Date of publication of application: 21.12.2011
(73) Proprietor: Grimme, 7736 PJ Beerze (NL)
(72) Inventor: Grimme, Geert, 7736 PJ Beerze (NL)
(74) Representative: van Someren, Petronella F. H. M.

(56) References cited:
- DE-A1- 10 104 297
- DE-U1-202004 009 677
- GB-A- 2 448 920
- US-A1- 2007 157 963

## Description

The present invention relates to a roof having roof tiles provided with solar cells. The invention also relates to an assembly of a roof tile and tile lath of such a roof, and to the roof tile individually.

Roof tiles provided with solar cells are generally known. They represent an attractive option for obtaining electrical energy through conversion of solar energy. The known roof tile takes a flat form and is provided on an upper side thereof with a solar cell panel. The solar cell panel has an electrical terminal for drawing off the electrical energy generated in the panel. The roof tile is placed on a tile lath. The tile lath can here be provided with electrical terminals complementary to the terminals on the solar cell panel. A plurality of roof tiles are in this way connected to a single tile lath.

A drawback of the known roof tiles is that the placing of the roof tile must take place accurately in order to obtain the alignment required between the complementary terminals on roof tile and tile lath. With the known roof tile it is therefore not possible to place the tile at a random position, and then particularly in the horizontal direction, on the tile lath. The placing of roof tiles is therefore time-consuming.

A further drawback of the known roofs with solar cell panels is that the electrical connection between roof tile and tile lath is susceptible to corrosion because it is exposed to weather influences. A solution to this problem is to work with shielded connectors. However, this increases the time required for placing of the roof tiles.

GB 2 448 920A discloses a roof tile comprising a solar energy collection device. The roof tile comprises an array of photovoltaic cells for converting solar energy into electrical energy.

It is an object of the present invention to provide a solution to at least one of the above problems. A further object of the invention is to increase the efficiency of the solar energy conversion.

At least one of these objects is achieved with a roof as defined in claim 1 which comprises a tile lath provided with a first elongate electrical conductor running parallel to the tile lath and covered with an insulating layer, in addition to a roof tile which rests on the tile lath. The roof tile according to the invention comprises a solar cell film attached to an upper side of the roof tile. Connected to the roof tile is a conductive piercing device by which electrical energy generated in the solar cell film can be drawn off.

The piercing device and the insulating layer are adapted such that when the roof tile is placed on the tile lath the piercing device pierces through the insulating layer. An electrical contact is hereby made between the piercing device and the first conductor.

In the present invention the alignment between roof tile and tile lath is therefore largely unnecessary because placing is not limited to a discrete position. The roof tile can be placed instead at a random position in the longitudinal direction of the conductor. The assembly of a roof will hereby proceed more quickly.

It is advantageous when the insulating layer is resilient and adapted to cover the electrical contact between the piercing device and the first conductor after placing of the roof tile in order to prevent corrosion. The resilience ensures that the space between the piercing device and the resilient layer is limited to a minimum, thereby reducing the danger of corrosion. The roof tile can hereby also be placed more easily since lesser requirements are made of the form of the piercing device and the method of placing.

Another or further advantage is achieved when the insulating layer is resilient and adapted, after removal of the roof tile from the tile lath, to move back resiliently for the purpose of closing a hole left by the piercing device. It hereby becomes possible to remove an erroneously placed or damaged roof tile and either set it back or replace it without the possibility of the first conductor corroding.

The resilient layer preferably comprises a layer of a material from the group consisting of silicones, asphalt, bitumen, rubber. It is advantageous here for the layer to take a transparent form, since this enables visual inspection of the conductor located thereunder. Corrosion, caused for instance by a crack in the layer, is thus visible from outside. A silicone layer is particularly suitable because of its shape-recovering capability. This provides for a good closure when the piercing device pierces through the layer. Also avoided is that the conductor(s) become(s) exposed after removal of the roof tile.

In an embodiment of the present invention the piercing device comprises a conductive, point-like structure. The point-like structure makes it possible to pierce the insulating layer easily. It will be apparent to the skilled person that other forms are likewise possible.

According to the invention, the tile lath comprises a second elongate electrical conductor which runs parallel to the tile lath and is placed at a distance from the first conductor, and which is covered with a or the insulating layer. The piercing device is here provided with a first and second point-like structure which, after placing of the roof tile, make electrical contact with respectively the first and second conductors. In this way both the positive and negative terminals of the solar cell film can be connected to conductors in or on the tile lath. If the roof comprises a plurality of roof tiles, the associated solar cell films can in this way be connected electrically in parallel by the first and second conductors.

In an embodiment of the invention the roof tile comprises one or more support structures with which the roof tile rests on the tile lath. The first and/or second point-like structure, the first and/or second conductor and the one or more support structures are preferably aligned with each other. This achieves that, when a roof tile is placed, the first and/or second point-like structure pierces the insulating layer at the correct location and thus makes contact with the conductor in or on the tile lath.

In an embodiment the first and/or second point-like structure or structures are attached to a support structure.

It is recommended that the first conductor extends in a plane parallel to the roof and the second conductor extends in a plane perpendicularly of the roof. The first point-like structure is adapted here to engage the first conductor in a direction perpendicularly of the roof and the second point-like structure is adapted to engage the tile lath in a direction parallel to the roof.

In an embodiment of the invention the piercing device comprises an angle profile with a first side which runs parallel to an underside of the roof tile and to which the first point-like structure is attached, and a second side which lies perpendicularly of the underside of the roof tile and to which the second point-like structure is attached. After placing of the roof tile the angle profile connects here to the tile lath. The angle profile itself also forms a support structure per se. The use of an angle profile facilitates the simultaneous engagement of the point-like structures. It is also advantageous if each roof tile is equipped at the same location with the same angle profile. A great uniformity is hereby obtained, whereby play between tile lath and roof tile is reduced. Also achieved is that each point-like structure engages the first or second conductor at the same transverse position. This makes it possible to use relatively narrow conductors.

If the angle profile is placed recessed into the roof tile, the thickness of the angle profile will not be a factor during placing of roof tile or tile lath, or hardly so. It is therefore advantageous to have the length of the first and second point-like structures substantially correspond in the direction of engagement to the thickness of the resilient layer. The play of roof tile on tile lath will be further reduced as a result of these measures.

The different tile laths in the roof can be coupled electrically by a third and fourth conductor for the purpose of drawing off the electrical energy generated in the solar cell film. Under normal conditions the tile laths are placed in horizontal direction. The tile laths are fixed to battens which are in turn mounted on the roof boarding. These battens usually lie in a direction from the ridge of the roof toward the roof gutter, perpendicularly of the tile laths to be placed later. This makes a batten suitable as carrier or mounting medium for the third conductor.

The known solar panel is a flat structure. However, the use of flexible solar cell film makes it possible to follow the contours of a roof tile. Applicant has found that placing of a flexible solar cell film over the undulation of a roof tile, whereby the solar cell film has the same undulation, results in a more efficient solar energy absorption.

It is advantageous if the first and/or second conductor are placed recessed into the tile lath. The roof tile can hereby fit properly against the tile lath. Additionally or instead, it can be advantageous for the insulating layer to be arranged at least locally for the purpose of insulating the first and/or second conductor. By combining the above measures it is even possible to adapt the insulating layer and the recessing of the first and/or second conductor to each other such that the side of the insulating layer facing toward the point-like structure lies in the same plane as the remaining upper side of the tile lath not covered with an insulating layer. It will be apparent to the skilled person that similar or further advantages can be gained by recessed placing of the piercing device in or on the roof tile and by modifying the length of the point-like structures to the thickness of the insulating layer.

In an embodiment of the roof according to the invention the roof comprises an electrical module for monitoring whether a current is flowing between the roof tile and tile lath. The module is preferably externally readable. Using such a module it is thus possible at a distance, remotely from the roof, such as indoors, to monitor whether the electrical contact between roof tile and tile lath is adequate.

It is advantageous to adapt the electrical module such that it measures the amount of current between roof tile and tile lath. Because this current is externally readable, the yield of a roof tile can be determined. The electrical module can be provided for this purpose with wireless communication means for transmitting measured values. An example hereof is RFID technology. In order to gain insight into the whole roof it is advantageous for the electrical module to be provided with an identification which is transmitted together with said measured values. This simplifies the measurement and external reading of a plurality of electrical modules. Per se known techniques can be used for remote reading of the electrical modules.

Such an electrical module is preferably situated in the piercing device. This makes it possible to measure the current per roof tile. In an embodiment wherein the piercing device is placed on the tile lath and the conductors are arranged on the roof tile it is however advantageous to arrange the electrical module on the roof tile. It will be apparent to the skilled person that the placing of the electrical module is preferably such that the current is measured per roof tile.

According to a further aspect, the invention provides an assembly of a roof tile and tile lath, wherein the roof tile and tile lath are embodied as described above. The invention likewise provides a roof tile as described above.

The invention will be discussed in more detail hereinbelow with reference to the accompanying figures, wherein:
Figure 1 is a schematic view of a partially cut-way roof according to the present invention;
Figure 2 is a perspective view of a part of the roof of figure 1;
Figure 3 is a perspective bottom view of a roof tile according to the present invention;
Figures 4A and 4B show perspective top views of a roof tile and a solar cell film which can be placed on the roof tile; and
Figures 5A-5C show a cross-section at the position of line V-V in figure 1.

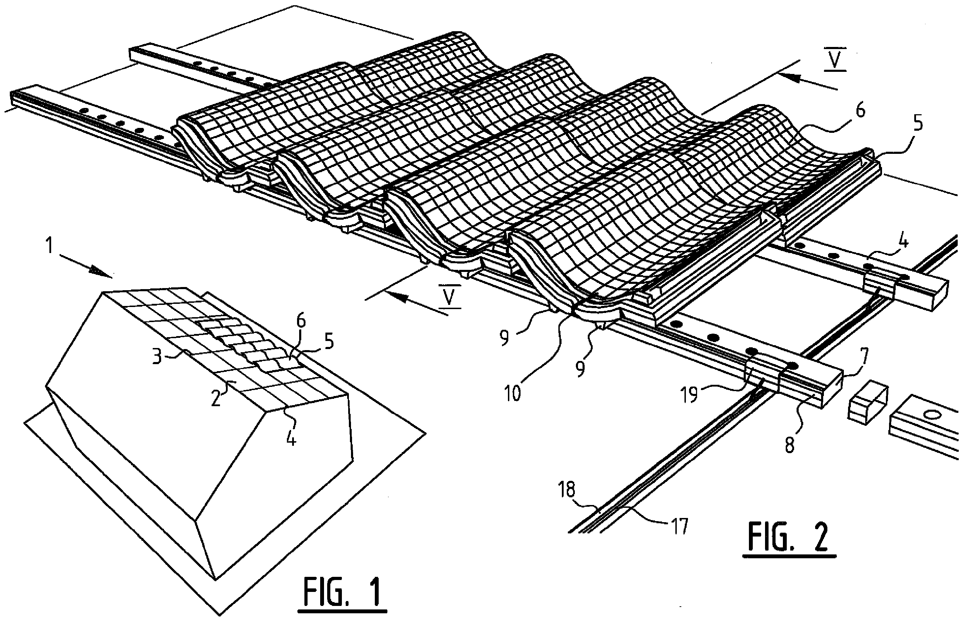

Figure 1 shows a schematic view of an embodiment of a roof 1 according to the present invention. Roof 1 comprises a roof boarding 2 usually consisting of sheet material. Placed on roof boarding 2 are a number of battens 3 extending from the ridge of the roof in the direction of the roof gutter. A number of horizontally placed tile laths 4 are fixed perpendicularly on battens 3. Tile laths 4 serve as support means for supporting roof tiles 5. Tile laths 4, or support means generally, are elongate in horizontal direction. Roof tiles 5 are placed on the tile laths, wherein adjacent roof tiles partially overlap each other.

A roof tile 5 comprises a solar cell film 6 placed on an upper side of roof tile 5. Roof tile 5 has a known undulation in a horizontal direction. Because solar cell film 6 is flexible, it follows the undulation of roof tile 5. Roof tile 5 is hereby able to optimally convert incident sunlight to electrical energy.

In figure 2 can be seen that tile lath 4 comprises two conductors 7, 8 which take an elongate form in a direction parallel to tile lath 4. A first conductor 7 is present in an upper side of tile lath 4 and a second conductor 8 is present in a rear side of tile lath 4. The rear side of tile lath 4 corresponds here to that side which would be visible as seen from the ridge of roof 1.

Also shown in figure 2 are the support structures 9
with which roof tile 5 rests on tile lath 4. Support structures 9 protrude from the bottom surface of roof tile 5. These structures are per se known.

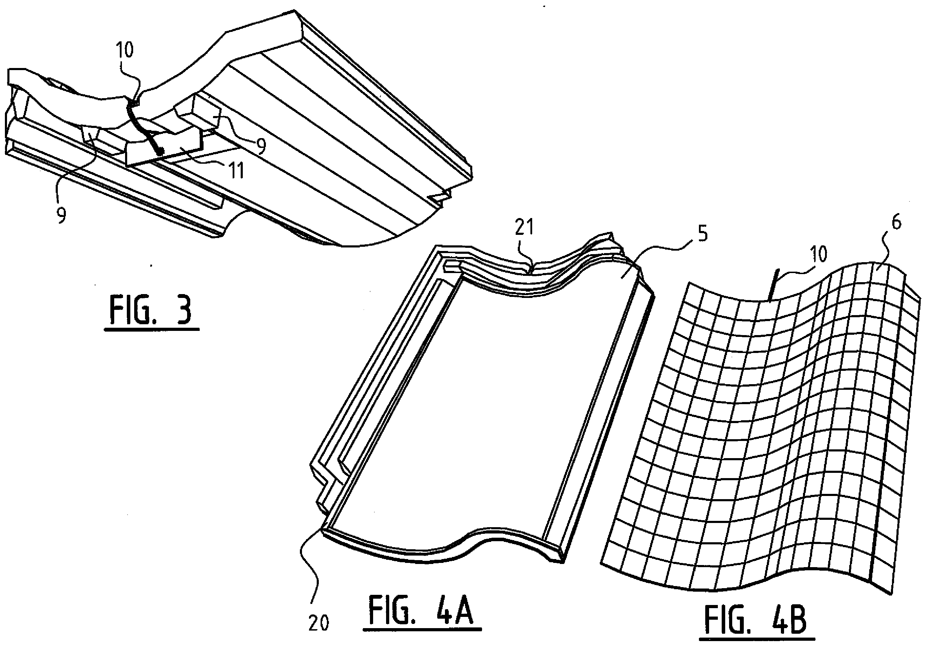

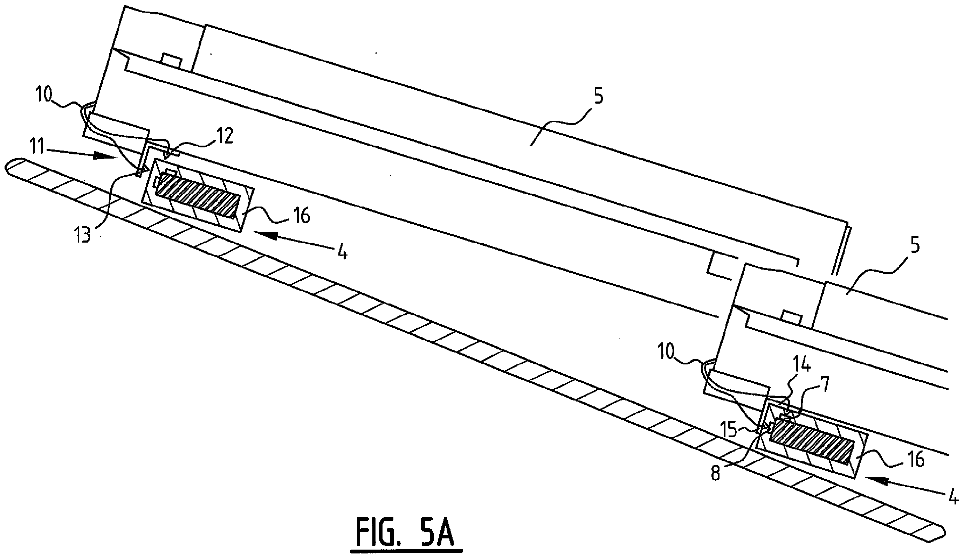

Solar cell film 6 has two electrical terminals. Electric wires 10 run from the top side of roof tile 5 to the underside. This underside is further shown in figures 3 and 5A-5C.

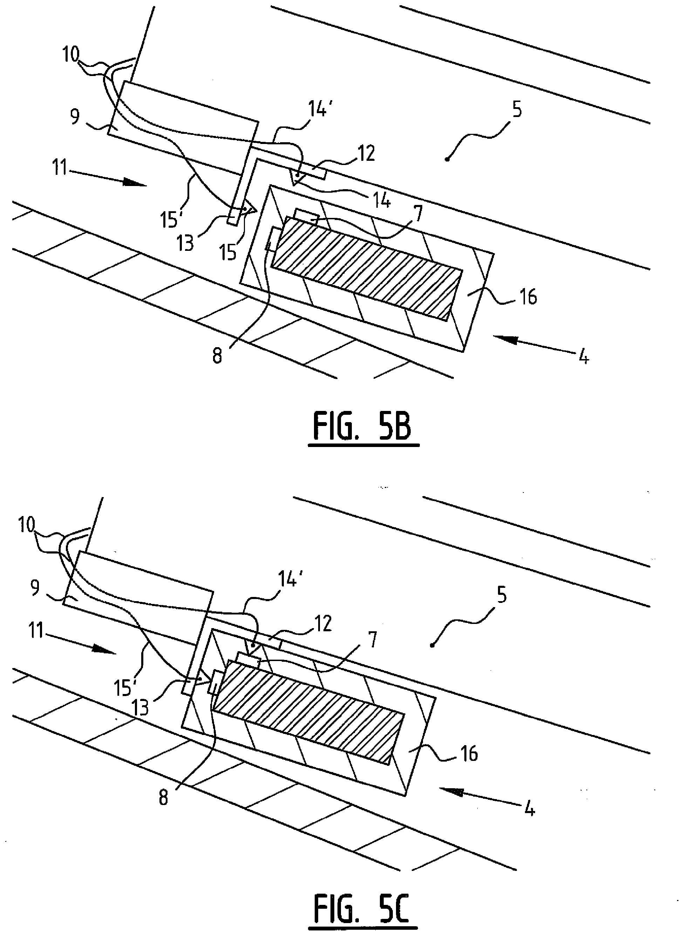

The electric wires run to a connector 11 embodied as an angle profile. Connector 11 has a first side 12 which runs parallel to the underside of roof tile 5 and a second side 13 placed perpendicularly thereof. Point-like structures 14, 15 are placed on these sides. Each point-like structure 14, 15 corresponds to a terminal of solar cell film 6. Figure 5 shows here that two conductors 15', 14' corresponding to the two electrical terminals of solar cell film 6 are incorporated in cabling 10.

The first 7 and second conductor 8 in tile lath 4 are covered with a silicone layer 16. Point-like structures 14, 15 are adapted here such that when roof tile 5 is placed they pierce silicone layer 16 and make electrical contact with conductors 7, 8. Figure 5A shows on the left the situation before placing and on the right the situation after placing. These situations are shown in more detail in respectively figure 5B and 5C.

Figures 5A-5C show conductors 7, 8 as being structures resting on the surface of tile lath 4. It is however advantageous to place conductors 7, 8 in recessed manner so that the surface of tile lath 4 with conductors 7, 8 has a flat profile. Silicone layer 16 is further shown enlarged for the purpose of illustration. Possible dimensions of the tile lath are 22 x 50 mm (width x height) with a 0.2 mm thick silicone layer 16. Silicone layer 16 can also be arranged only at the position of conductors 7, 8.

Tile lath 4 is preferably manufactured from foamed plastic. This is easy to process and is not electrically conductive. It is also possible to place conductors 7, 8 in a mould during forming of the tile lath.

After placing, silicone layer 16 will enclose the electrical contact, whereby the danger of corrosion either disappears or is greatly reduced. If a roof tile 5 must be removed or replaced, silicone layer 16 will move back resiliently after removal of roof tile 5 so that the holes left by the point-like structures 14, 15 are filled.

Conductors 7, 8 provide for the drawing off of electrical energy generated in solar cell film 6. Tile lath 4 is connected electrically to a plurality of electrical solar cell films 6. These films are connected in parallel. In figure 2 different tile laths 4 are connected electrically to each other by means of a third 17 and fourth 18 conductor forming part of a cable. An electrical coupling 19 provides for an electrical connection between third conductor 17 and first conductor 7 and between fourth conductor 18 and second conductor 8. It is also possible to place a plurality of tile laths 4 adjacently of each other and couple them electrically. Use is preferably made of injection-moulded plastic components. These components are provided with similar point-like structures as the piercing device. In an embodiment the coupling comprises a plastic component provided on two sides thereof with point-like structures, preferably one for each conductor on the tile laths to be connected. There are therefore for instance four point-like structures in total, two for each tile lath.

Owing to the coupling between tile laths it becomes possible to draw off the generated electrical energy with a single third 17 and fourth 18 conductor. It will be apparent to the skilled person that a plurality of conductors can also be used.

Electrical coupling 19 can likewise be manufactured with an angle profile. An example hereof is shown in figure 2. This angle profile can also be provided with point-like structures for the purpose of making contact with conductors 7, 8 in tile lath 4. The angle profile can therefore be shaped in the same way as connector 11. Attachment of electrical coupling 19 can take place with snap connections as known to the skilled person. It is likewise possible to connect coupling 19 fixedly to tile lath 4.

Figure 4A shows a top view of a roof tile 5. Compared to a known roof tile without solar cell film 6, the roof tile according to the invention comprises an upright edge 20 which defines a space for placing of solar cell film 6. Further provided on the upper side of roof tile 5 is a recess 21 for throughfeed of electrical wiring 10 of solar cell film 6.

In the above embodiment tile lath 4 comprises a silicone layer covering conductors 7, 8. It is however possible to use another insulating layer. The use of a resilient layer is recommended since this reduces the danger of corrosion. A single insulating layer can nevertheless provide sufficient protection from corrosion provided the point-like structures pierce this layer in the correct direction and do not make a larger hole than is strictly necessary. It will be apparent to the skilled person that the use of a resilient layer considerably reduces standard requirements here.

The present invention is discussed in the foregoing on the basis of embodiments thereof. It will be apparent to the skilled person that the present invention is not limited thereto and that various modifications are possible.

The term tile lath need not therefore be interpreted as relating only to a wooden elongate structure. Any element fulfilling the same function can be deemed a tile lath.

In the above description the piercing device is further attached to the roof tile and the conductor with insulating layer on or in the tile lath. It is however also possible to reverse this. It is thus possible to provide the underside of the roof tile with two conductors running at a mutual distance and covered with an insulating layer and to provide the tile lath with piercing devices. The same placing advantage as described above is achieved by placing the piercing devices at various locations on the tile lath.

It is likewise possible to provide a roof tile on an upper side with a first conductor covered with an insulating layer and on the underside with a piercing device. Adjacent roof tiles can here be placed in series; the piercing device of a roof tile engages on the conductor on an adjacent roof tile. The first roof tile can once again be freely placed. As final roof tile of a row of roof tiles placed in series a roof tile can be used which has two point-like structures on the underside. The tile lath is provided here with two conductors which run parallel and one of which is engaged by the first roof tile of the series connection and the other by the final roof tile in the series. At the final roof tile one point-like structure will thus engage the conductor of a preceding roof tile, while the other point-like structure engages the other conductor on the tile lath.

It will be apparent to the skilled person that further modifications are possible without departing from the scope of protection defined by the appended claims.

## Claims

1. A roof (1), comprising:
a tile lath (4) provided with a first elongate electrical conductor (7) and with a second elongate electrical conductor (8) placed at a distance from the first conductor, wherein the first electrical conductor and the second electrical conductor each run parallel to the tile lath and are covered with an insulating layer (16);
a roof tile (5) which rests on the tile lath, said roof tile comprising an undulation;
a solar cell film (6) attached to an upper side of the roof tile;
a conductive piercing device which is connected to the roof tile and by which electrical energy generated in the solar cell film can be drawn off;
wherein the piercing device and the insulating layer are adapted such that when the roof tile is placed on the tile lath the piercing device pierces through the insulating layer for the purpose of making electrical contact between the piercing device and the first conductor and second conductor, wherein the piercing device is provided with a first (14) and second (15) point-like structure which, after placing of the roof tile on the tile lath, make electrical contact with respectively the first and second conductor;
wherein the solar cell film has an undulation corresponding to the undulation of the roof tile; and
wherein the first conductor extends in a plane parallel to the roof and the second conductor extends in a plane perpendicularly of the roof, and wherein the first point-like structure is adapted to engage the first conductor in a direction perpendicularly of the roof and the second point-like structure is adapted to engage the second conductor in a direction parallel to the roof.

2. The roof as claimed in claim 1, wherein the first and/or second elongate electrical conductor is placed recessed into the tile lath, wherein the second conductor and the first conductor are preferably arranged in the tile lath in a recessed manner such that the surfaces of the tile lath with the first and second conductor have a flat profile.

3. The roof as claimed in claim 1 or 2, wherein the insulating layer is resilient and adapted to cover the electrical contact between the piercing device and the first conductor after placing of the roof tile in order to prevent corrosion, wherein the resilient layer preferably comprises a layer of a material from the group consisting of silicones, asphalt, bitumen, rubber; and
wherein the insulating layer is furthermore adapted to, after removal of the roof tile from the tile lath, move back resiliently for the purpose of closing a hole left by the piercing device.

4. The roof as claimed in claim 3, wherein the resilient layer consists of silicones.

5. The roof as claimed in any of the foregoing claims, wherein the resilient layer is arranged only at the position of the first and second conductor.

6. The roof as claimed in any of the foregoing claims, wherein the tile lath is manufactured from foamed plastic, wherein the connection between the first and second conductor is formed by placing the first and second conductor in a mould for manufacturing the tile lath during forming of the tile lath.

7. The roof as claimed in any of the foregoing claims, comprising a plurality of roof tiles, the solar cell films of which are connected electrically in parallel by the first and second conductors.

8. The roof as claimed in any of the foregoing claims, wherein the roof tile comprises one or more support structures (9) with which the roof tile rests on the tile lath, and wherein the first and/or second point-like structure, the first and/or second conductor and the one or more support structures are aligned with each other, wherein the first and/or second point-like structure is preferably attached to a support structure.

9. The roof as claimed in any of the foregoing claims, wherein the piercing device comprises an angle profile with a first side which runs parallel to an underside of the roof tile and to which the first point-like structure is attached, and a second side which lies perpendicularly of the underside of the roof tile and to which the second point-like structure is attached, wherein after placing of the roof tile the angle profile connects to the tile lath, wherein the angle profile is preferably placed recessed into the roof tile and wherein the length of the first and second point-like structures preferably substantially corresponds in the direction of engagement to the thickness of the insulating layer.

10. The roof as claimed in any of the foregoing claims, comprising a third (17) and fourth (18) conductor coupled electrically to a plurality of tile laths for the purpose of drawing off the electrical energy generated in the solar cell film, wherein the third and fourth conductor are preferably connected to or received in a batten (3) of the roof.

11. The roof as claimed in any of the foregoing claims, wherein the insulating layer is arranged at least locally for the purpose of insulating the first and/or second conductor.

12. The roof as claimed in any of the foregoing claims, further comprising an electrical module for monitoring whether a current is flowing between the roof tile and tile lath, wherein the electrical module is externally readable and is preferably adapted to measure the amount of current between roof tile and tile lath and/or wherein the electrical module comprises wireless communication means for transmitting measured values, wherein the electrical module is preferably provided with an identification which is transmitted together with said measured values.

13. An assembly of the roof tile and tile lath as defined in any of the foregoing claims.

14. A roof tile (5) configured to be used in the roof (1) as defined in any of the claims 1-12, and comprising:
an undulation;
a solar cell film (6) arranged at an upper side of the roof tile;
a conductive piercing device by which electrical energy generated in the solar cell film can be drawn off;
wherein the piercing device and the insulating layer (16) of the tile lath (4) of the roof as defined in any of the claims 1-12 are adapted such that when the roof tile is placed on the tile lath, the piercing device pierces through the insulating layer for the purpose of making electrical contact between the piercing device and the first conductor (7) and second conductor (8) of the tile lath, wherein the piercing device is provided with a first (14) and second (15) point-like structure which, after placing of the roof tile on the tile lath, make electrical contact with respectively the first and second conductor of the tile lath;
wherein the solar cell film has an undulation corresponding to the undulation of the roof tile; and
wherein the first point-like structure is adapted to engage the first conductor of the tile lath in a direction perpendicularly of the roof and the second point-like structure is adapted to engage the tile lath of the roof in a direction parallel to the roof.

## Patentansprüche

1. Dach (1), das aufweist:
eine Zielgellatte (4), die mit einem ersten länglichen elektrischen Leiter (7) und mit einem zweiten länglichen elektrischen Leiter (8), der in einem Abstand von dem ersten Leiter angeordnet ist, versehen ist, wobei der erste elektrische Leiter und der zweite elektrische Leiter jeweils parallel zu der Ziegellatte verlaufen und mit einer Isolierschicht (16) bedeckt sind;
einen Dachziegel (5), der auf der Ziegellatte aufliegt, wobei der Dachziegel eine Wellenform aufweist;
eine Solarzellendünnschicht (6), die an einer Oberseite des Dachziegels befestigt ist;
eine leitfähige Durchbohrungsvorrichtung, die mit dem Dachziegel verbunden ist und durch die in der Solarzellendünnschicht erzeugte elektrische Energie abgezogen werden kann;
wobei die Durchbohrungsvorrichtung und die Isolierschicht derart angepasst sind, dass die Durchbohrungsvorrichtung, wenn der Dachziegel auf der Ziegellatte angeordnet wird, die Isolierschicht zu dem Zweck durchbohrt, den elektrischen Kontakt zwischen der Durchbohrungsvorrichtung und dem ersten Leiter und dem zweiten Leiter herzustellen,
wobei die Durchbohrungsvorrichtung mit einer ersten (14) und einer zweiten (15) punktartigen Struktur versehen ist, die, nachdem der Dachziegel auf der Ziegellatte angeordnet wurde, jeweils den elektrischen Kontakt mit dem ersten und zweiten Leiter herstellt;
wobei die Solarzellendünnschicht eine Wellenform hat, die der Wellenform des Dachziegels entspricht; und
wobei der erste Leiter sich in einer Ebene parallel zu dem Dach erstreckt und der zweite Leiter sich in einer Ebene senkrecht zu dem Dach erstreckt, und wobei die erste punktartige Struktur geeignet ist, in einer Richtung senkrecht zu dem Dach an dem ersten Leiter anzugreifen, und die zweite punktartige Struktur geeignet ist, in einer Richtung parallel zu dem Dach an dem zweiten Leiter anzugreifen.

2. Dach nach Anspruch 1, wobei der erste und/oder zweite längliche elektrische Leiter in die Ziegellatte vertieft angeordnet ist, wobei der zweite Leiter und der erste Leiter vorzugsweise in einer vertieften Weise in der Ziegellatte angeordnet sind, so dass die Oberflächen der Ziegellatte mit dem ersten und zweiten Leiter ein ebenes Profil haben.

3. Dach nach Anspruch 1 oder 2, wobei die Isolierschicht elastisch ist und geeignet ist, den elektrischen Kontakt zwischen der Durchbohrungsvorrichtung und dem ersten Leiter nach dem Anordnen des Dachziegels abzudecken, um Korrosion zu verhindern, wobei die elastische Schicht vorzugsweise eine Schicht aus einem Material aus der Gruppe aufweist, die aus Silikonen, Asphalt, Bitumen, Gummi besteht; und
wobei die Isolierschicht außerdem geeignet ist, sich nach dem Entfernen des Dachziegels von der Ziegellatte zu dem Zweck elastisch zurück zu bewegen, ein Loch, das durch die Durchbohrungsvorrichtung bleibt, zu schließen.

4. Dach nach Anspruch 3, wobei die elastische Schicht aus Silikonen besteht.

5. Dach nach einem der vorhergehenden Ansprüche, wobei die elastische Schicht nur an der Position des ersten und zweiten Leiters angeordnet ist.

6. Dach nach einem der vorhergehenden Ansprüche, wobei die Ziegellatte aus geschäumtem Kunststoff hergestellt ist, wobei die Verbindung zwischen dem ersten und zweiten Leiter durch Anordnen des ersten und zweiten Leiters in einer Form zur Herstellung der Ziegellatte während des Ausbildens der Ziegellatte ausgebildet wird.

7. Dach nach einem der vorhergehenden Ansprüche, das eine Vielzahl von Dachziegeln aufweist, deren Solarzellendünnschichten durch die ersten und zweiten Leiter parallel geschaltet sind.

8. Dach nach einem der vorhergehenden Ansprüche, wobei der Dachziegel ein oder mehrere Haltestrukturen (9) aufweist, mit denen der Dachziegel auf der Ziegellatte aufliegt, und wobei die erste und/oder zweite punktartige Struktur, der erste und/oder zweite Leiter und die eine oder mehreren Haltestrukturen miteinander ausgerichtet sind, wobei die erste und/oder zweite punktartige Struktur vorzugsweise an einer Haltestruktur befestigt ist.

9. Dach nach einem der vorhergehenden Ansprüche, wobei die Durchbohrungsvorrichtung ein Winkelprofil mit einer ersten Seite, die parallel zu einer Unterseite des Dachziegels verläuft und an der die erste punktartige Struktur befestigt ist, und einer zweiten Seite, die senkrecht zu der Unterseite des Dachziegels liegt und an der die zweite punktartige Struktur befestigt ist, aufweist, wobei das Winkelprofil nach dem Anordnen des Dachziegels mit der Ziegellatte verbindet, wobei das Winkelprofil vorzugsweise in das Dach vertieft angeordnet ist, und wobei die Länge der ersten und zweiten punktartigen Strukturen in der Eingreifrichtung im Wesentlichen der Dicke der Isolierschicht entspricht.

10. Dach nach einem der vorhergehenden Ansprüche, das einen dritten (17) und vierten (18) Leiter aufweist, der zu dem Zweck, die in der Solarzellenfolie erzeugte elektrische Energie abzuziehen, mit einer Vielzahl von Ziegellatten elektrisch verbunden ist, wobei der dritte und vierte Leiter vorzugsweise mit einer Latte (3) des Dachs verbunden oder darin aufgenommen sind.

11. Dach nach einem der vorhergehenden Ansprüche, wobei die Isolierschicht wenigstens lokal zu dem Zweck der Isolierung des ersten und/oder zweiten Leiters angeordnet ist.

12. Dach nach einem der vorhergehenden Ansprüche, das ferner ein elektrisches Modul zur Überwachung aufweist, ob ein Strom zwischen dem Dachziegel und der Ziegellatte fließt, wobei das elektrische Modul extern lesbar ist und vorzugsweise geeignet ist, um die Strommenge zwischen dem Dachziegel und der Ziegellatte zu messen, und/oder wobei das elektrische Modul drahtlose Kommunikationsmittel zur Übertragung von Messwerten aufweist, wobei das elektrische Modul vorzugsweise mit einer Kennung versehen ist, die zusammen mit den Messwerten übertragen wird.

13. Anordnung des Dachziegels und der Ziegellatte, wie in jedem der vorhergehenden Ansprüche definiert.

14. Dachziegel (5), der aufgebaut ist, um in dem Dach (1), wie in jedem der Ansprüche 1 - 12 definiert, verwendet zu werden, und der aufweist:
eine Wellenform;
eine Solarzellendünnschicht (6), die an einer Oberseite des Dachziegels befestigt ist;
eine leitfähige Durchbohrungsvorrichtung, durch die in der Solarzellendünnschicht erzeugte elektrische Energie abgezogen werden kann;
wobei die Durchbohrungsvorrichtung und die Isolierschicht (16) der Ziegellatte (4) des Dachs, wie in jedem der Ansprüche 1 - 12 definiert, derart angepasst sind, dass die Durchbohrungsvorrichtung, wenn der Dachziegel auf der Ziegellatte angeordnet wird, die Isolierschicht zu dem Zweck durchbohrt, den elektrischen Kontakt zwischen der Durchbohrungsvorrichtung und dem ersten Leiter (7) und dem zweiten Leiter (8) der Ziegellatte herzustellen, wobei die Durchbohrungsvorrichtung mit einer ersten (14) und einer zweiten (15) punktartigen Struktur versehen ist, die, nachdem der Dachziegel auf der Ziegellatte angeordnet wurde, jeweils den elektrischen Kontakt mit dem ersten und zweiten Leiter der Ziegellatte herstellt;
wobei die Solarzellendünnschicht eine Wellenform hat, die der Wellenform des Dachziegels entspricht; und
wobei die erste punktartige Struktur geeignet ist, in einer Richtung senkrecht zu dem Dach an dem ersten Leiter der Ziegellatte anzugreifen, und die zweite punktartige Struktur geeignet ist, in einer Richtung parallel zu dem Dach an dem zweiten Leiter anzugreifen.

## Revendications

1. Toiture (1) comprenant :
un liteau de support de tuiles (4) pourvu d'un premier conducteur électrique allongé (7) et d'un second conducteur allongé (8) placé à une distance du premier conducteur, dans lequel le premier conducteur électrique et le second conducteur électrique s'étendent parallèlement au liteau de support de tuiles et sont recouverts d'une couche isolante (16) ;
une tuile de toiture (5) qui repose sur le liteau de support de tuiles, ladite tuile de toiture comprenant une ondulation ;
un film de cellule solaire (6) fixé à un côté supérieur de la tuile de toiture ;
un dispositif de perçage conducteur qui est relié à la tuile de toiture et au moyen duquel une énergie électrique générée dans le film de cellule solaire peut être extraite ;
dans laquelle le dispositif de perçage et la couche isolante sont adaptés de telle sorte que lorsque la tuile de toiture est placée sur le liteau de support de tuiles, le dispositif de perçage perce la couche isolante aux fins d'établir un contact électrique entre le dispositif de perçage et le premier conducteur et le second conducteur, dans laquelle le dispositif de perçage est pourvu d'une première (14) et d'une seconde (15) structure de type pointe qui, après mise en place de la tuile de toiture sur le liteau de support de tuiles, établissent un contact électrique avec le premier et le second conducteur respectivement ;
dans laquelle le film de cellule solaire présente une ondulation correspondant à l'ondulation de la tuile de toiture ; et
dans laquelle le premier conducteur s'étend dans un plan parallèle à la toiture et le second conducteur s'étend dans un plan perpendiculaire à la toiture, et dans laquelle la première structure de type pointe est adaptée pour se mettre en prise avec le premier conducteur dans une direction perpendiculaire à la toiture et la seconde structure de type pointe est adaptée pour se mettre en prise avec le second conducteur dans une direction parallèle à la toiture.

2. Toiture selon la revendication 1, dans laquelle le premier et/ou le second conducteur électrique allongé est placé de manière renfoncée dans le liteau de support de tuiles, dans laquelle le second conducteur et le premier conducteur sont de préférence agencés dans le liteau de support de tuiles d'une manière renfoncée de telle sorte que les surfaces du liteau de support de tuiles avec le premier et le second conducteur ont un profil plat.

3. Toiture selon la revendication 1 ou 2, dans laquelle la couche isolante est élastique et adaptée pour couvrir le contact électrique entre le dispositif de perçage et le premier conducteur après mise en place de la tuile de toiture afin de prévenir la corrosion, dans laquelle la couche élastique comprend de préférence une couche de matériau du groupe constitué de silicones, d'asphalte, de bitume, de caoutchouc ; et
dans laquelle la couche isolante est en outre adaptée, après retrait de la tuile de toiture du liteau de support de tuiles, pour revenir de manière élastique afin de fermer un trou laissé par le dispositif de perçage.

4. Toiture selon la revendication 3, dans laquelle la couche élastique est constituée de silicones.

5. Toiture selon l'une quelconque des revendications précédentes, dans laquelle la couche élastique est agencée uniquement à la position du premier et du second conducteur.

6. Toiture selon l'une quelconque des revendications précédentes, dans laquelle le liteau de support de tuiles est fabriqué à partir de plastique expansé, dans laquelle la connexion entre le premier et le second conducteur est formée en plaçant le premier et le second conducteur dans un moule pour fabriquer le liteau de support de tuiles pendant le formage du liteau de support de tuiles.

7. Toiture selon l'une quelconque des revendications précédentes, comprenant une pluralité de tuiles de toiture, dont les films de cellules solaires sont connectés électriquement en parallèle par les premier et second conducteurs.

8. Toiture selon l'une quelconque des revendications précédentes, dans laquelle la tuile de toiture comprend une ou plusieurs structures de support (9) avec lesquelles la tuile de toiture repose sur le liteau de support de tuiles, et dans laquelle la première et/ou la seconde structure de type pointe, le premier et/ou le second conducteur et les une ou plusieurs structures de support sont alignés les uns avec les autres, dans laquelle la première et/ou la seconde structure de type pointe est de préférence fixée à une structure de support.

9. Toiture selon l'une quelconque des revendications précédentes, dans laquelle le dispositif de perçage comprend un profil d'angle avec une première face qui s'étend parallèlement à une face inférieure de la tuile de toiture et à laquelle est fixée la première structure de type pointe, et une seconde face qui repose perpendiculairement à la face inférieure de la tuile de toiture et à laquelle est fixée la seconde structure de type pointe, dans laquelle après mise en place de la tuile de toiture, le profil d'angle se connecte au liteau de support de tuiles, dans laquelle le profil d'angle est de préférence placé de manière renfoncée dans la tuile de toiture et dans laquelle la longueur des première et seconde structures de type pointe correspond de préférence sensiblement dans la direction de mise en prise à l'épaisseur de la couche isolante.

10. Toiture selon l'une quelconque des revendications précédentes, comprenant un troisième (17) et un quatrième (18) conducteur couplés électriquement à une pluralité de liteaux de support de tuiles aux fins d'extraire l'énergie électrique générée dans le film de cellule solaire, dans laquelle le troisième et le quatrième conducteur sont de préférence connectés à un chevron (3) de la toiture ou reçus dans celui-ci.

11. Toiture selon l'une quelconque des revendications précédentes, dans laquelle la couche isolante est agencée au moins localement aux fins d'isoler le premier et/ou le second conducteur.

12. Toiture selon l'une quelconque des revendications précédentes, comprenant en outre un module électrique pour surveiller si un courant passe entre la tuile de toiture et le liteau de support de tuiles, dans laquelle le module électrique est lisible de manière externe et est de préférence adapté pour mesurer la quantité de courant entre la tuile de toiture et le liteau de support de tuiles et/ou dans laquelle le module électrique comprend des moyens de communication sans fil pour transmettre les valeurs mesurées, dans laquelle le module électrique est de préférence pourvu d'une identification qui est transmise conjointement avec lesdites valeurs mesurées.

13. Ensemble de la tuile de toiture et du liteau de support de tuiles selon l'une quelconque des revendications précédentes.

14. Tuile de toiture (5) configurée pour être utilisée dans la toiture (1) selon l'une quelconque des revendications 1 à 12, et comprenant :
une ondulation ;
un film de cellule solaire (6) agencé au niveau d'une face supérieure de la tuile de toiture ;
un dispositif de perçage conducteur au moyen duquel l'énergie électrique générée dans le film de cellule solaire peut être extraite ;
dans laquelle le dispositif de perçage et la couche isolante (16) du liteau de support de tuiles (4) de la toiture selon l'une quelconque des revendications 1 à 12 sont adaptés de telle sorte que lorsque la tuile de toiture est placée sur le liteau de support de tuiles, le dispositif de perçage perce la couche isolante aux fins d'établir un contact électrique entre le dispositif de perçage et le premier conducteur (7) et le second conducteur (8) du liteau de support de tuiles, dans laquelle le dispositif de perçage est pourvu d'une première (14) et d'une seconde (15) structure de type pointe qui, après mise en place de la tuile de toiture sur le liteau de support de tuiles, établissent un contact électrique avec le premier et le second conducteur du liteau de support de tuiles respectivement ;
dans laquelle le film de cellule solaire présente une ondulation correspondant à l'ondulation de la tuile de toiture ; et
dans laquelle la première structure de type pointe est adaptée pour se mettre en prise avec le premier conducteur du liteau de support de tuiles dans une direction perpendiculaire à la toiture et la seconde structure de type pointe est adaptée pour se mettre en prise avec le liteau de support de tuiles de la toiture dans une direction parallèle à la toiture.
